# EUROPEAN PATENT SPECIFICATION

(11) **EP 2 169 466 B1**
(45) Date of publication and mention of the grant of the patent: **07.06.2017**
(21) Application number: 09168787.1
(22) Date of filing: 27.08.2009
(51) Int. Cl.: G03F 7/20, G01N 21/00, G02B 21/00

(54) **Inspection apparatus and method for sphero-chromatic aberration correction**
Prüfvorrichtung und Verfahren zum Korrigieren der sphärochromatischen Aberration
Appareil d'inspection et procédé pour la correction d'aberrations sphéro-chromatiques

(30) Priority: 30.09.2008 US 101284 P
(43) Date of publication of application: 31.03.2010
(73) Proprietor: ASML Holding N.V., 5504 DR Veldhoven (NL)
(72) Inventor: Ryzhikov, Lev, Norwalk, CT 6851 (US)
(74) Representative: Slenders, Petrus J. W.

(56) References cited:
- DE-A1- 3 812 745
- US-A1- 2006 091 781
- RUDOLF KINGSLAKE: "Lens design fundamentals" 1978, ACADEMIC PRESS LIMITED , LONDON , XP002561124 * page 123 *
- Stanislav Smirnov ET AL: "Optical Imaging: Inspection applications push imaging lenses into the deep - Laser Focus World", Laser Focus World, 1 July 2008 (2008-07-01), XP055322993, Retrieved from the Internet: URL:http://www.laserfocusworld.com/article s/print/volume-44/issue-7/features/optical -imaging-inspection-applications-push-imag ing-lenses-into-the-deep.html [retrieved on 2016-11-25]

## Description

### Field

Embodiments of the present invention generally relate to lithography, and more particularly to methods of inspection usable, for example, in the manufacture of devices by lithographic techniques and to methods of manufacturing devices using lithographic techniques.

### Background

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. including part of, one, or several dies) on a substrate (e.g. a silicon wafer). Transfer of the pattern is typically via imaging onto a layer of radiation-sensitive material (e.g., resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.

In order to monitor the lithographic process, it is necessary to measure parameters of the patterned substrate, for example the overlay error between successive layers formed in or on it. There are various techniques for making measurements of the microscopic structures formed in lithographic processes, including the use of scanning electron microscopes and various specialized tools. One form of specialized inspection tool is a scatterometer in which a beam of radiation is directed onto a target on the surface of the substrate and properties of the scattered or reflected beam are measured. By comparing the properties of the beam before and after it has been reflected or scattered by the substrate, the properties of the substrate can be determined. This can be done, for example, by comparing the reflected beam with data stored in a library of known measurements associated with known substrate properties. Two main types of scatterometer are known. Spectroscopic scatterometers direct a broadband radiation beam onto the substrate and measure the spectrum (intensity as a function of wavelength) of the radiation scattered into a particular narrow angular range. Angularly resolved scatterometers use a monochromatic radiation beam and measure the intensity of the scattered radiation as a function of angle.

The radiation sources that are normally used to produce radiation for the inspection/measurement processes have a nominal illumination wavelength value and the semiconductor inspection system is configured for this value. However, the actual illumination wavelength of the radiation source may be different from the nominal illumination wavelength value. This wavelength drift may result in sphero-chromatic aberration in the semiconductor inspection system. The further away the actual illumination wavelength is from the nominal illumination wavelength, the greater the sphero-chromatic aberration may be in the semiconductor inspection system.

In order to minimize the effects of this wavelength drift, particularly sphero-chromatic aberration, optical systems have previously included one or more lenses at least partially made of calcium fluoride (CAF2). For example, optical systems may include lenses made entirely of CAF2. Optical systems may also include achromatic lenses, which are paired or tripled lenses made of CAF2 and other materials, such as fused silica. CAF2 is an expensive material, however, so use of CAF2 lenses results in increased costs for optical systems.

WO2006/091781 discloses scatterometers and methods of using scatterometry to determine several parameters of periodic microstructures, pseudo-periodic structures, and other very small structures having features sizes as small as 100 nm or less. Several specific embodiments of the scatterometers may be useful in the semiconductor industry to determine the width, depth, line edge roughness, wall angle, film thickness, and many other parameters of the features formed in microprocessors, memory devices, and other semiconductor devices. The scatterometers and methods of WO2006/091781 may also be applied in other applications. A scatterometer disclosed in WO2006/091781 contains a CMOS detector without a flat, parallel cover between focal lens and CMOS chip.

### SUMMARY

Given the foregoing, the inventor has discovered a system and method to inexpensively minimize the effects of wavelength drift by sphero-chromatic aberration correction in a lithographic system that does not require the use of costly CAF2 lenses.

According to an embodiment of the invention, there is provided a semiconductor inspection system according to claim 1.

Also according to an embodiment of the present invention, there is provided a method for reducing effects of a wavelength drift of a light source in a semiconductor inspection system according to claim 6.

### BRIEF DESCRIPTION OF THE DRAWINGS/FIGURES

Embodiments of the invention will now be described, by way of example only, with reference to the accompanying schematic drawings in which corresponding reference symbols indicate corresponding parts, and in which:
Figures 1A and 1B respectively depict reflective and transmissive lithographic apparatuses.
Figure 2 schematically depicts a lithographic cell or cluster.
Figure 3 schematically depicts a scatterometer that may be used in an embodiment of the present invention.
Figure 4 illustrates features of a semiconductor inspection system according to an embodiment of the present invention.
Figure 5 is a flowchart of a method according to an embodiment of the present invention.
Figure 6 schematically depicts graphs of various measurements for an exemplary semiconductor inspection system consistent with embodiments of the present invention.
Figure 7 schematically depicts graphs of various measurements for an example uncorrected system consistent with embodiments of the present invention.
Figure 8 schematically depicts graphs of various measurements for an example corrected system consistent with embodiments of the present invention.
Figure 9 schematically depicts graphs of various measurements for an example uncorrected system consistent with embodiments of the present invention.
Figure 10 schematically depicts graphs of various measurements for an example corrected system consistent with embodiments of the present invention.
Figure 11 schematically depicts graphs of various measurements for an exemplary semiconductor inspection system consistent with embodiments of the present invention.
Figure 12 schematically depicts graphs of various measurements for an example uncorrected system consistent with embodiments of the present invention.
Figure 13 schematically depicts graphs of various measurements for an example corrected system consistent with embodiments of the present invention.
Figure 14 schematically depicts graphs of various measurements for an example uncorrected system consistent with embodiments of the present invention.
Figure 15 schematically depicts graphs of various measurements for an example corrected system consistent with embodiments of the present invention.

### DETAILED DESCRIPTION

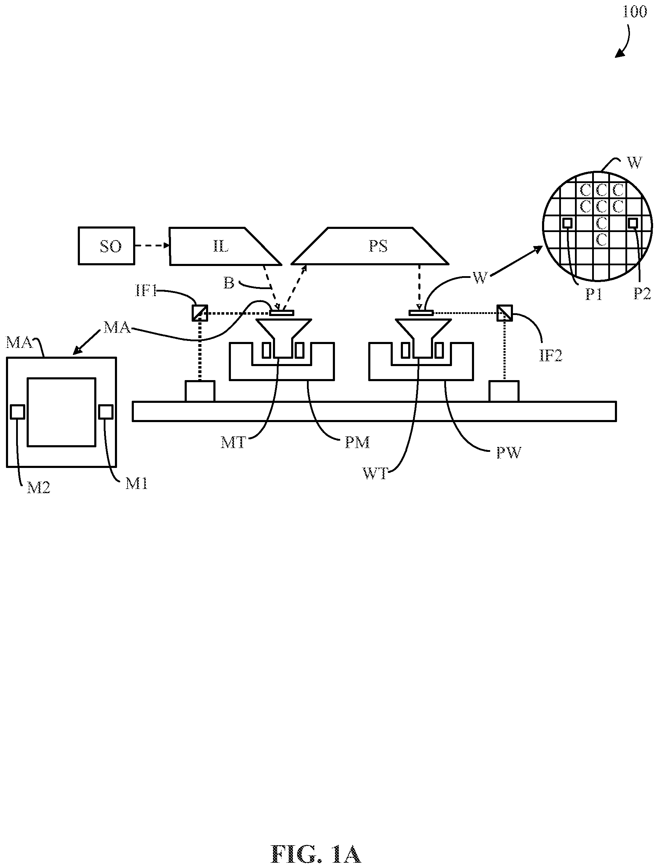

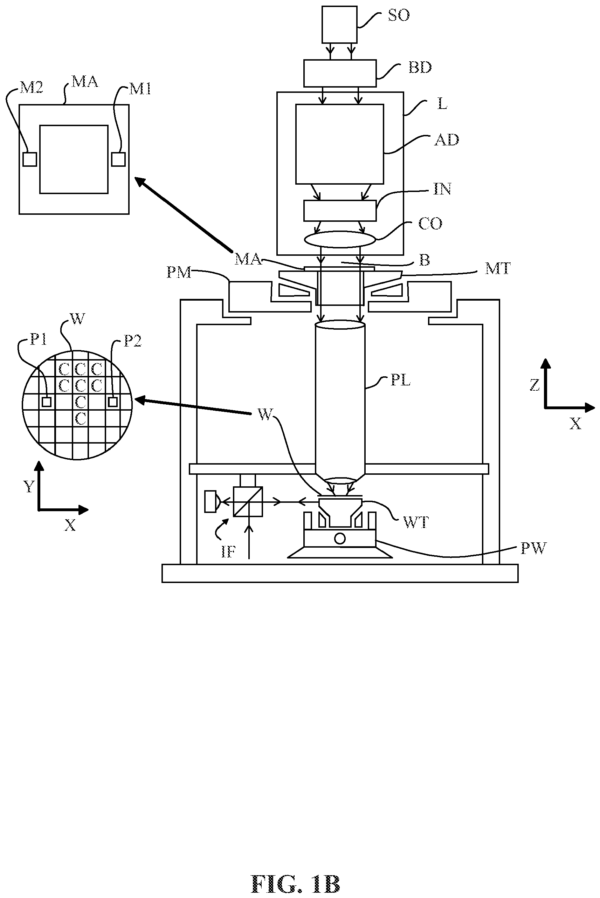

FIGS. 1A and 1B schematically depict lithographic apparatus 100 and lithographic apparatus 100', respectively. Lithographic apparatus 100 and lithographic apparatus 100' each include: an illumination system (illuminator) IL configured to condition a radiation beam B (e.g., DUV or EUV radiation); a support structure (e.g., a mask table) MT configured to support a patterning device (e.g., a mask, a reticle, or a dynamic patterning device) MA and connected to a first positioner PM configured to accurately position patterning device MA; and a substrate table (e.g., a wafer table) WT configured to hold a substrate (e.g., a resist coated wafer) W and connected to a second positioner PW configured to accurately position substrate W. Lithographic apparatuses 100 and 100' also have a projection system PS configured to project a pattern imparted to radiation beam B by patterning device MA onto a target portion (e.g., comprising one or more dies) C of substrate W. In lithographic apparatus 100 patterning device MA and projection system PS are reflective, and in lithographic apparatus 100' patterning device MA and projection system PS are transmissive.

Illumination system IL may include various types of optical components, such as refractive, reflective, magnetic, electromagnetic, electrostatic or other types of optical components, or any combination thereof, for directing, shaping, or controlling radiation beam B.

Support structure MT holds patterning device MA in a manner that depends on the orientation of patterning device MA, the design of lithographic apparatuses 100 and 100', and other conditions, such as for example whether or not patterning device MA is held in a vacuum environment. Support structure MT may use mechanical, vacuum, electrostatic or other clamping techniques to hold patterning device MA. Support structure MT may be a frame or a table, for example, which may be fixed or movable, as required. Support structure MT may ensure that the patterning device is at a desired position, for example with respect to projection system PS.

The term "patterning device" MA should be broadly interpreted as referring to any device that may be used to impart a radiation beam B with a pattern in its cross-section, such as to create a pattern in target portion C of substrate W. The pattern imparted to radiation beam B may correspond to a particular functional layer in a device being created in target portion C, such as an integrated circuit.

Patterning device MA may be transmissive (as in lithographic apparatus 100' of FIG. 1B) or reflective (as in lithographic apparatus 100 of FIG. 1A). Examples of patterning devices MA include reticles, masks, programmable mirror arrays, and programmable LCD panels. Masks are well known in lithography, and include mask types such as binary, alternating phase shift, and attenuated phase shift, as well as various hybrid mask types. An example of a programmable mirror array employs a matrix arrangement of small mirrors, each of which may be individually tilted so as to reflect an incoming radiation beam in different directions. The tilted mirrors impart a pattern in the radiation beam B which is reflected by the mirror matrix.

The term "projection system" PS may encompass any type of projection system, including refractive, reflective, catadioptric, magnetic, electromagnetic and electrostatic optical systems, or any combination thereof, as appropriate for the exposure radiation being used, or for other factors, such as the use of an immersion liquid or the use of a vacuum. A vacuum environment may be used for EUV or electron beam radiation since other gases may absorb too much radiation or electrons. A vacuum environment may therefore be provided to the whole beam path with the aid of a vacuum wall and vacuum pumps.

Lithographic apparatus 100 and/or lithographic apparatus 100' may be of a type having two (dual stage) or more substrate tables (and/or two or more mask tables) WT. In such "multiple stage" machines the additional substrate tables WT may be used in parallel, or preparatory steps may be carried out on one or more tables while one or more other substrate tables WT are being used for exposure.

Referring to FIGS. 1A and 1B, illuminator IL receives a radiation beam from a radiation source SO. Source SO and lithographic apparatuses 100, 100' may be separate entities, for example when source SO is an excimer laser. In such cases, source SO is not considered to form part of lithographic apparatuses 100 or 100', and radiation beam B passes from source SO to illuminator IL with the aid of a beam delivery system BD (FIG. 1B) including, for example, suitable directing mirrors and/or a beam expander. In other cases, source SO may be an integral part of lithographic apparatuses 100, 100' - for example when source SO is a mercury lamp. Source SO and illuminator IL, together with beam delivery system BD, if required, may be referred to as a radiation system.

Illuminator IL may include an adjuster AD (FIG. 1B) for adjusting the angular intensity distribution of the radiation beam. Generally, at least the outer and/or inner radial extent (commonly referred to as σ-outer and σ-inner, respectively) of the intensity distribution in a pupil plane of the illuminator may be adjusted. In addition, illuminator IL may include various other components (FIG. 1B), such as an integrator IN and a condenser CO. Illuminator IL may be used to condition radiation beam B, to have a desired uniformity and intensity distribution in its cross section.

Referring to FIG. 1A, radiation beam B is incident on patterning device (e.g., mask) MA, which is held on support structure (e.g., mask table) MT, and is patterned by patterning device MA. In lithographic apparatus 100, radiation beam B is reflected from patterning device (e.g., mask) MA. After being reflected from patterning device (e.g., mask) MA, radiation beam B passes through the projection system PS, which focuses radiation beam B onto a target portion C of the substrate W. With the aid of the second positioner PW and position sensor IF2 (e.g., an interferometric device, linear encoder or capacitive sensor), substrate table WT may be moved accurately, e.g. so as to position different target portions C in the path of radiation beam B. Similarly, first positioner PM and another position sensor IF1 may be used to accurately position patterning device (e.g., mask) MA with respect to the path of radiation beam B. Patterning device (e.g., mask) MA and substrate W may be aligned using mask alignment marks M1, M2 and substrate alignment marks P1, P2.

Referring to FIG. 1B, radiation beam B is incident on patterning device (e.g., mask MA), which is held on support structure (e.g., mask table MT), and is patterned by the patterning device. Having traversed mask MA, radiation beam B passes through projection system PS, which focuses the beam onto a target portion C of substrate W. With the aid of second positioner PW and position sensor IF (e.g., an interferometric device, linear encoder or capacitive sensor), substrate table WT can be moved accurately, e.g. so as to position different target portions C in the path of radiation beam B. Similarly, first positioner PM and another position sensor (which is not explicitly depicted in FIG. 1B) can be used to accurately position mask MA with respect to the path of radiation beam B, e.g., after mechanical retrieval from a mask library, or during a scan.

In general, movement of mask table MT may be realized with the aid of a long-stroke module (coarse positioning) and a short-stroke module (fine positioning), which form part of first positioner PM. Similarly, movement of substrate table WT may be realized using a long-stroke module and a short-stroke module, which form part of second positioner PW. In the case of a stepper (as opposed to a scanner) mask table MT may be connected to a short-stroke actuator only, or may be fixed. Mask MA and substrate W may be aligned using mask alignment marks M1, M2 and substrate alignment marks PI, P2. Although the substrate alignment marks as illustrated occupy dedicated target portions, they may be located in spaces between target portions (known as scribe-lane alignment marks). Similarly, in situations in which more than one die is provided on mask MA, the mask alignment marks may be located between the dies.

Lithographic apparatuses 100 and 100' may be used in at least one of the following modes:
1. In step mode, support structure (e.g., mask table) MT and substrate table WT are kept essentially stationary, while an entire pattern imparted to radiation beam B is projected onto a target portion C at one time (i.e., a single static exposure). Substrate table WT is then shifted in the X and/or Y direction so that a different target portion C may be exposed.
2. In scan mode, support structure (e.g., mask table) MT and substrate table WT are scanned synchronously while a pattern imparted to radiation beam B is projected onto a target portion C (i.e., a single dynamic exposure). The velocity and direction of substrate table WT relative to support structure (e.g., mask table) MT may be determined by the (de-)magnification and image reversal characteristics of projection system PS.
3. In another mode, support structure (e.g., mask table) MT is kept substantially stationary holding a programmable patterning device, and substrate table WT is moved or scanned while a pattern imparted to radiation beam B is projected onto a target portion C. A pulsed radiation source SO may be employed and the programmable patterning device is updated as required after each movement of substrate table WT or in between successive radiation pulses during a scan. This mode of operation may be readily applied to maskless lithography that utilizes programmable patterning device, such as a programmable mirror array of a type as referred to herein.

Combinations and/or variations on the described modes of use or entirely different modes of use may also be employed.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat-panel displays, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion," respectively. The substrate referred to herein may be processed, before or after exposure, in for example a track (a tool that typically applies a layer of resist to a substrate and develops the exposed resist), a metrology tool and/or an inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

In a further embodiment, lithographic apparatus 100 includes an extreme ultraviolet (EUV) source, which is configured to generate a beam of EUV radiation for EUV lithography. In general, the EUV source is configured in a radiation system (see below), and a corresponding illumination system is configured to condition the EUV radiation beam of the EUV source.

In the embodiments described herein, the terms "lens" and "lens element," where the context allows, may refer to any one or combination of various types of optical components, comprising refractive, reflective, magnetic, electromagnetic and electrostatic optical components.

Further, the terms "radiation" and "beam" used herein encompass all types of electromagnetic radiation, comprising ultraviolet (UV) radiation (e.g., having a wavelength λ of 365, 248, 193, 157 or 126 nm), extreme ultra-violet (EUV or soft X-ray) radiation (*e.g.,* having a wavelength in the range of 5-20 nm, *e.g.,* 13.5 nm), or hard X-ray working at less than 5nm, as well as particle beams, such as ion beams or electron beams. Generally, radiation having wavelengths between about 780-3000 nm (or larger) is considered IR radiation. UV refers to radiation with wavelengths of approximately 100-400 nm. Within lithography, it is usually also applied to the wavelengths, which can be produced by a mercury discharge lamp: G-line 436 nm; H-line 405 nm; and/or I-line 365 nm. Vacuum UV, or VUV (*i.e.,* UV absorbed by air), refers to radiation having a wavelength of approximately 100-200 nm. Deep UV (DUV) generally refers to radiation having wavelengths ranging from 126 nm to 428 nm, and in an embodiment, an excimer laser can generate DUV radiation used within lithographic apparatus. It should be appreciated that radiation having a wavelength in the range of, for example, 5-20 nm relates to radiation with a certain wavelength band, of which at least part is in the range of 5-20 nm.

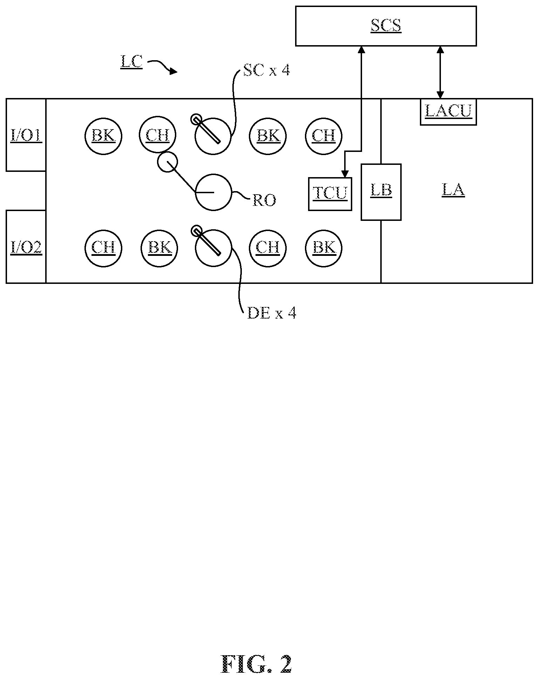

As shown in Figure 2, lithographic apparatus LA forms part of a lithographic cell LC, also sometimes referred to as a lithocell or cluster, which also includes apparatus to perform pre- and post-exposure processes on a substrate. Conventionally these include spin coaters SC to deposit resist layers, developers DE to develop exposed resist, chill plates CH and bake plates BK. A substrate handler, or robot, RO picks up substrates from input/output ports I/O1, I/O2, moves them between the different process apparatus and delivers then to loading bay LB of the lithographic apparatus. These devices, which are often collectively referred to as the track, are under the control of a track control unit TCU which is itself controlled by the supervisory control system SCS, which also controls the lithographic apparatus via lithography control unit LACU. Thus, the different apparatus can be operated to maximize throughput and processing efficiency.

In order that the substrates that are exposed by the lithographic apparatus are exposed correctly and consistently, it is desirable to inspect exposed substrates to measure properties such as overlay errors between subsequent layers, line thicknesses, critical dimensions (CD), etc. If errors are detected, adjustments may be made to exposures of subsequent substrates, especially if the inspection can be done soon and fast enough that other substrates of the same batch are still to be exposed. Also, already exposed substrates may be stripped and reworked - to improve yield - or discarded - thereby avoiding performing exposures on substrates that are known to be faulty. In a case where only some target portions of a substrate are faulty, further exposures can be performed only on those target portions which are good.

An inspection apparatus is used to determine the properties of the substrates, and in particular, how the properties of different substrates or different layers of the same substrate vary from layer to layer. The inspection apparatus may be integrated into lithographic apparatus LA or lithocell LC or may be a stand-alone device. To enable most rapid measurements, it is desirable that the inspection apparatus measure properties in the exposed resist layer immediately after the exposure. However, the latent image in the resist has a very low contrast - there is only a very small difference in refractive index between the parts of the resist which have been exposed to radiation and those which have not - and not all inspection apparatus have sufficient sensitivity to make useful measurements of the latent image. Therefore measurements may be taken after the post-exposure bake step (PEB) which is customarily the first step carried out on exposed substrates and increases the contrast between exposed and unexposed parts of the resist. At this stage, the image in the resist may be referred to as semi-latent. It is also possible to make measurements of the developed resist image - at which point either the exposed or unexposed parts of the resist have been removed - or after a pattern transfer step such as etching. The latter possibility limits the possibilities for rework of faulty substrates but may still provide useful information.

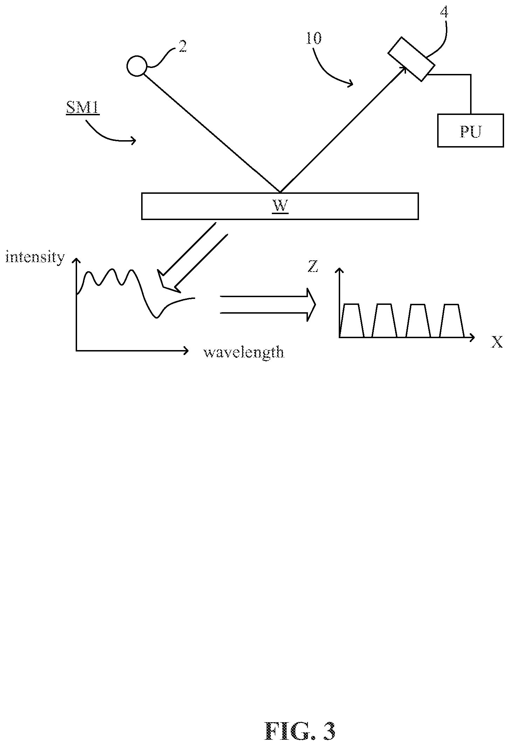

Figure 3 depicts a scatterometer which may be used in an embodiment of the present invention. It includes a broadband (white light) radiation projector 2 which projects radiation onto a substrate W. The reflected radiation is passed to a spectrometer detector 4, which measures a spectrum 10 (intensity as a function of wavelength) of the specular reflected radiation. From this data, the structure or profile giving rise to the detected spectrum may be reconstructed by processing unit PU, e.g. by Rigorous Coupled Wave Analysis and non-linear regression or by comparison with a library of simulated spectra as shown at the bottom of Figure 3. In general, for the reconstruction the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

In an embodiment, any other type of detector may be used in place of or in addition to the scatterometer.

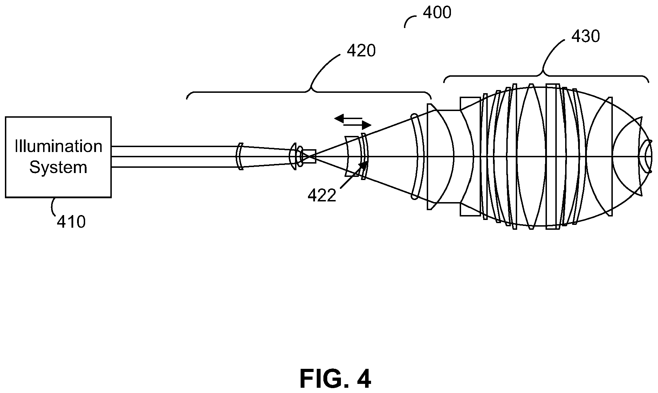

Figure 4 illustrates features of a semiconductor inspection system 400 according to an embodiment of the present invention. An illumination system 410 is used to transfer radiation to an optical system. In the illustrated embodiment, the optical system includes a telescope system 420 and an objective lens system 430. A light beam emitted by illumination system 410 at a given wavelength is transmitted to telescope system 420. Telescope system 420 is an afocal portion of the optical system, and includes a set of lenses configured to magnify the light beam. Telescope system 420 may magnify the light beam either positively or negatively depending on the specific design, as would be evident to one of skill in the art. Once properly magnified, the light beam is transmitted to objective lens system 430.

Objective lens system 430 may include a single lens or may include a plurality of lenses. Objective lens system 430 conditions the light beam for output.

Illumination system 410 may include any suitable source of radiation. In an embodiment, illumination system 410 is a laser that emits light in the DUV range of the electromagnetic spectrum. DUV generally refers to radiation having wavelengths ranging from approximately 126 nm to 428 nm.

The optics of semiconductor inspection system 400 may be designed to process light at a particular wavelength. This wavelength will be referred to herein as the nominal wavelength of the inspection system. For example, if the nominal wavelength of the inspection system is 266.09 nm, telescope system 420 and objective lens system 430 should process illumination light having a wavelength of 266.09 nm with minimal sphero-chromatic aberration. Sphero-chromatic aberration is a change in spherical aberration corresponding to wavelength. Spherical aberration is aberration in an image due to the shape of a lens and its effect on a focal point. For example, a perfect lens should focus all incoming light rays to the same point on the optical axis. However, a real lens may focus light rays to different points, depending on whether the light rays enter the lens at the edge of the lens or at the center of the lens. The different focal points cause imperfections in the image and are the effects of spherical aberration. If the wavelength of the illumination light differs from the nominal wavelength of the system, sphero-chromatic aberration may be introduced by the lenses in the inspection system. Because of tolerance variances within an individual laser, a given laser may not output illumination light at its exact specification wavelength. For example, a laser having a specification of 266.09 nm may actually output light in a range of approximately 266.05 nm to 266.13 nm. This is referred to as wavelength drift.

When used in an optical system that is designed to meet precise wavelength specifications, such as semiconductor inspection system 400, this wavelength drift in the illumination system may result in sphero-chromatic aberration in semiconductor inspection system 400. The further away the actual illumination wavelength is from the nominal wavelength of the inspection system, the greater the sphero-chromatic aberration may be in semiconductor inspection system 400.

To minimize the effects of wavelength drift and sphero-chromatic aberration, a correction may be introduced in telescope system 420. In particular, telescope system 420 may include at least one moveable lens, such as in one embodiment being a zoomable lens (a lens that has variable working distances, so consequent images are either smaller or larger since it allows continuous shift of working distances without shifting the focus point and therefore provides the versatility of having several focal length lenses in one convenient lens) that is positioned such that sphero-chromatic aberration in semiconductor inspection system 400 is minimized or meets a user-defined tolerance. As illustrated in Figure 4, at least one of the lenses in telescope system 420 is a moveable lens 422. Moveable lens 422 is moveable along an optical axis of telescope system 420. Since the wavelength of the illumination light output by illumination system 410 is difficult to change, moveable lens 422 allows the nominal wavelength of semiconductor inspection system 400 to be changed to substantially match that of the illumination wavelength. As different illumination systems 410 are used with semiconductor inspection system 400, the position of moveable lens 422 can be changed so that semiconductor inspection system 400 as a whole does not have to be recreated when the actual illumination wavelength changes.

The position of moveable lens 422 needed to change the nominal wavelength of system 400 appropriately depends on multiple factors. One factor is the actual illumination wavelength output by illumination system 410. Another factor is the starting position of each lens.

In an embodiment, the identification of moveable lens 422 is determined using modeling software. For example, using modeling software, a position of a given lens can be adjusted, with a corresponding change in the sphero-chromatic aberration for a particular wavelength recorded. In an embodiment, the sphero-chromatic aberration within semiconductor inspection system 400 may be measured using a detector. The sphero-chromatic aberration measurement may be monitored as the position of moveable lens 422 is changed. The position of moveable lens 422 may be determined when the sphero-chromatic aberration is at an acceptable level, according to tolerances or levels defined by a user or any other source. One of skill in the art will recognize that such an analysis may be made for a plurality of lenses in telescope system 420, as well as for a plurality of wavelengths.

In an embodiment, the position of moveable lens 422 is determined by monitoring the intensity or quality of an image using a detector. The position of moveable lens 422 may be determined using user-defined tolerances for image intensity, sharpness, quality, and/or any other suitable variable.

In an embodiment, the lenses in telescope system 420 are made of fused silica. However, this should not be construed as limiting. The lenses in telescope system 420 may be made of any suitable material, including CAF2.

In the embodiment depicted in Figure 4, moveable lens 422 is the third lens from objective lens system 430 but this is only an example. Moveable lens 422 may be any lens within telescope system 420.

In an embodiment, moveable lens 422 has a small absolute value of optical power relative to the other lenses in telescope system 420. In an embodiment, moveable lens 422 has an absolute value of optical power in the range of approximately 0.002 to 0.01.

In an embodiment, moveable lens 422 may be a plurality or group of moveable lenses. In an embodiment the group of moveable lenses has an absolute value of optical power in the range of approximately 0.002 to 0.01. The moveable lenses in the group of moveable lenses may or may not be adjacent to one another along the optical axis.

In an embodiment, the position of moveable lens 422 may be determined with respect to illumination system 410, objective lens system 430, or any other point within semiconductor inspection system 400. For example, the position of moveable lens 422 may be determined with respect to one or more of the other lenses within telescope system 420.

In an embodiment, moveable lens 422 is positioned manually. In another embodiment, moveable lens 422 is positioned using a controller and software.

In an embodiment, semiconductor inspection system 400 further includes a detector to measure the wavelength of the radiation transmitted by objective lens system 430.

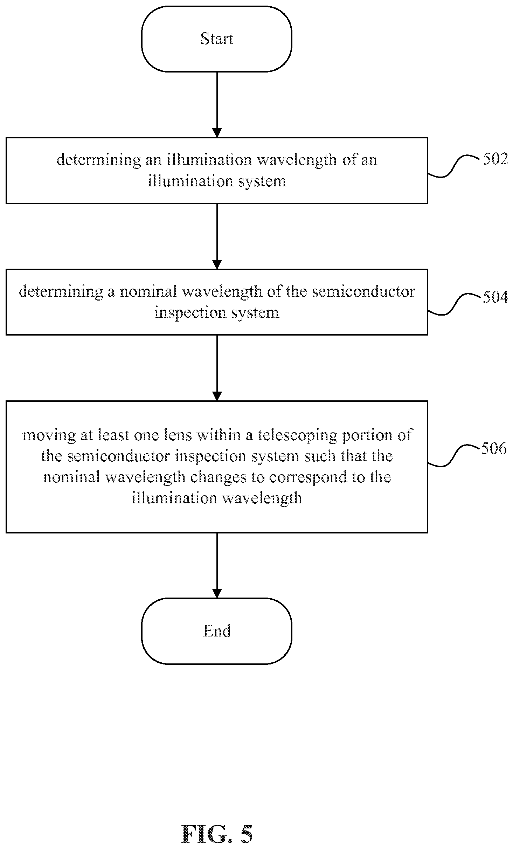

Figure 5 depicts a method for minimizing the effects of wavelength drift and sphero-chromatic aberration in a semiconductor inspection system, such as semiconductor inspection system 400. In step 502, the actual illumination wavelength of the illumination system, such as illumination system 410, is determined. In an embodiment, the actual illumination wavelength of the illumination system may be determined using a spectrometer or any other suitable device.

In step 504, the nominal wavelength of the semiconductor inspection system is determined. In an embodiment, the nominal wavelength of the inspection system is known based on the design specifications of the inspection system. In another embodiment, the nominal wavelength is determined by any other method known to those of skill in the art.

In step 506, at least one lens within a telescope system of the inspection system, such as lens 422 in telescope system 420, is moved. In an embodiment, the lens is moved along the optical axis of the semiconductor inspection system. In an embodiment, the lens is moved while the nominal wavelength of the semiconductor inspection system is monitored. The moveable lens is positioned such that the nominal wavelength of the semiconductor inspection system changes so as to correspond to the actual illumination wavelength of the illumination system.

In an embodiment, the position of the moveable lens is determined in step 506 using modeling software. In an embodiment, the moveable lens has a small absolute value of optical power relative to the other lenses in the telescope system. In an embodiment, the moveable lens has an absolute value of optical power in the range of approximately 0.002 to 0.01.

Although embodiments of the invention have been described in relation to the embodiment shown in Figure 4, it will be appreciated that various changes may be made to the apparatus and still be in accordance with an embodiment of the invention. For example, any lens may be moved within the telescope system.

In another embodiment, in step 506 a group of lenses within the telescope system may be moved such that the nominal wavelength changes to correspond to the illumination wavelength of the particular illumination system. Each lens in the group is moved along the optical axis. In an embodiment the group of moveable lenses has an absolute value of optical power in the range of approximately 0.002 to 0.01. The moveable lenses in the group of moveable lenses may or may not be adjacent to one another along the optical axis.

In an embodiment, the telescope system may be interchanged with other telescope systems in other semiconductor inspection systems.

As herein described, correction for wavelength drift and sphero-chromatic aberration may be performed in afocal telescope system 420 and not in objective lens system 430. If a lens in objective lens system 430 were moved, adjusted, substituted, or otherwise altered, other measurements in semiconductor inspection system 400 would be affected as well. For example, additional distortion or aberration may be introduced. By performing the correction in telescope system 420, all other parameters remain relatively unchanged.

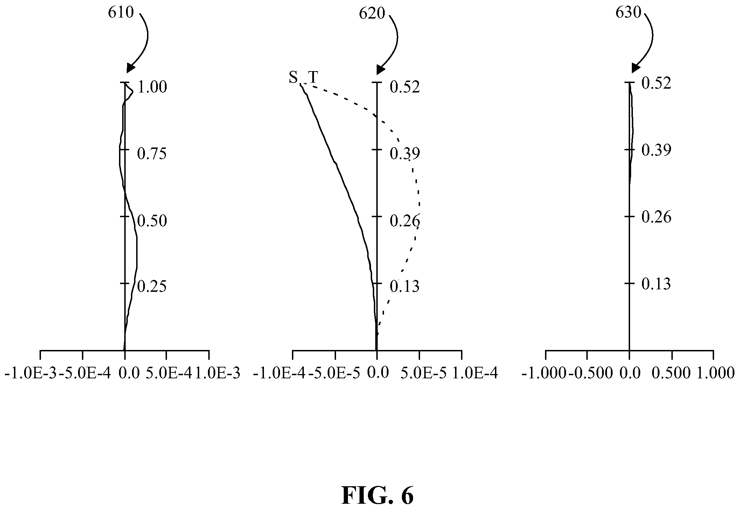

As an example, Figure 6 depicts measurements within an exemplary semiconductor inspection system. The graphs displayed in Figure 6 depict measurements from a system in which the nominal wavelength of the system is 266.09 nm and the actual illumination wavelength of the particular illumination source is 266.09 nm. Graph 610 depicts the longitudinal sphero-chromatic aberration in the system. In this example, sphero-chromatic aberration is minimized and no additional correction is necessary. Graph 620 depicts astigmatism and field curves for the same system. Graph 630 depicts the distortion present in the same system.

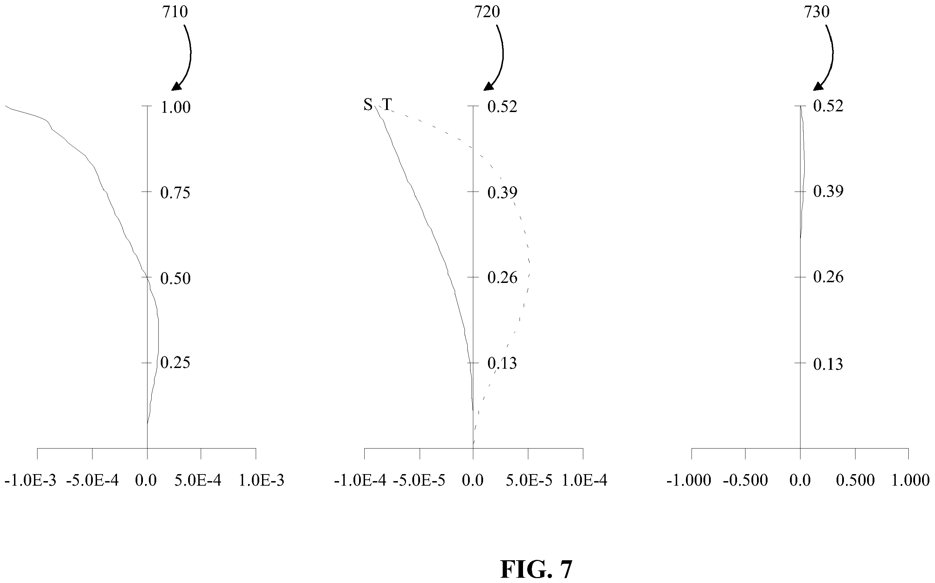

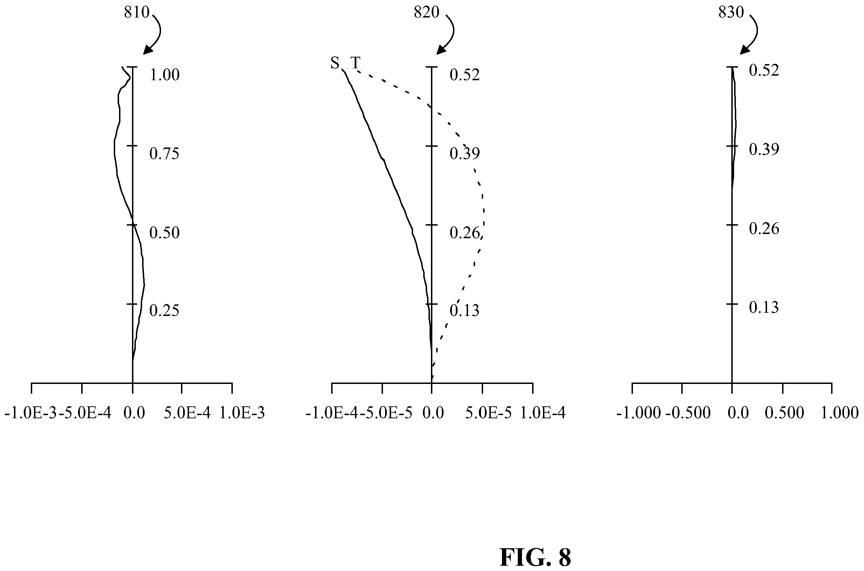

Figures 7 and 8 respectively depict measurements within another exemplary semiconductor inspection system before and after the sphero-chromatic aberration correction described above has been applied. The graphs displayed in Figure 7 depict measurements from a system which has not been corrected for sphero-chromatic aberration. In this example, the nominal wavelength of the system is 266.09 nm and the actual illumination wavelength of the particular illumination source is 266.05 nm. Graph 710 depicts the measured longitudinal sphero-chromatic aberration in the uncorrected system. Graph 720 depicts astigmatism and field curves for the same system. Graph 730 depicts the distortion present in the same system.

The graphs in Figure 8 depict the same system as depicted in Figure 7 after sphero-chromatic aberration correction according to an embodiment of the present invention has been applied. The nominal wavelength of the semiconductor inspection system has been changed to correspond to the actual illumination wavelength of 266.05 nm. Graph 810 depicts the measured longitudinal sphero-chromatic aberration in the corrected system. As can be seen by comparison to Graph 710, longitudinal sphero-chromatic aberration has been significantly reduced in the corrected system. Graph 820 depicts astigmatism and field curves for the same system after the correction has been applied. As can be seen by comparison to Graph 720, astigmatism and field curves remain relatively unchanged by the correction. Graph 830 depicts the distortion present in the same system after the correction has been applied. As can be seen by comparison to Graph 730, distortion within the system remains relatively unchanged by the correction.

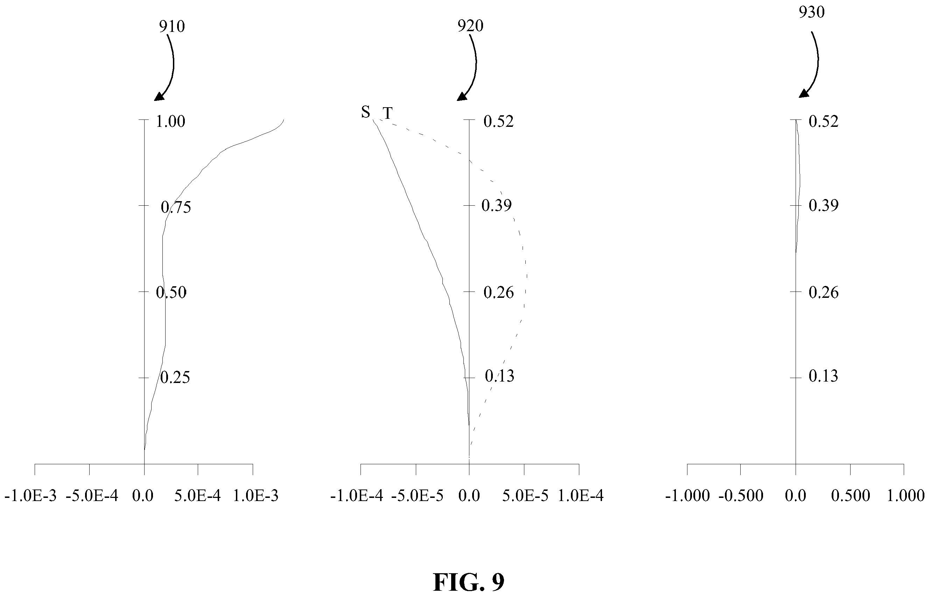

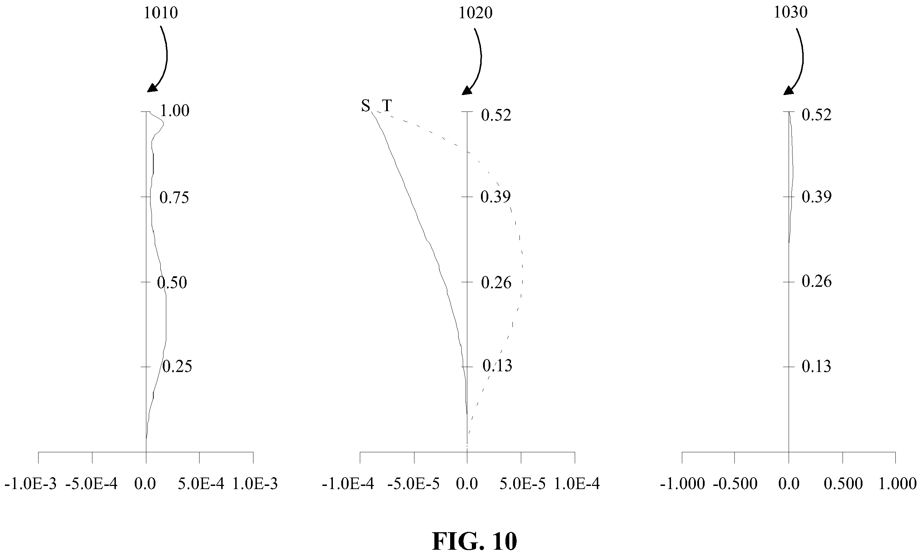

Figures 9 and 10 respectively depict measurements within another exemplary semiconductor inspection system before and after the sphero-chromatic aberration correction described above has been applied. The graphs displayed in Figure 9 depict measurements from a system which has not been corrected for sphero-chromatic aberration. In this example, the nominal wavelength of the system is 266.09 nm and the actual illumination wavelength of the particular illumination source is 266.13 nm. Graph 910 depicts the measured longitudinal sphero-chromatic aberration in the uncorrected system. Graph 920 depicts astigmatism and field curves for the same system. Graph 930 depicts the distortion present in the same system.

The graphs in Figure 10 depict the same system as depicted in Figure 9 after sphero-chromatic aberration correction according to an embodiment of the present invention has been applied. The nominal wavelength of the semiconductor inspection system has been changed to correspond to the actual illumination wavelength of 266.13 nm. Graph 1010 depicts the measured longitudinal sphero-chromatic aberration in the corrected system. As can be seen by comparison to Graph 910, longitudinal sphero-chromatic aberration has been significantly reduced in the corrected system. Graph 1020 depicts astigmatism and field curves for the same system after the correction has been applied. As can be seen by comparison to Graph 920, astigmatism and field curves remain relatively unchanged by the correction. Graph 1030 depicts the distortion present in the same system after the correction has been applied. As can be seen by comparison to Graph 930, distortion within the system remains relatively unchanged by the correction.

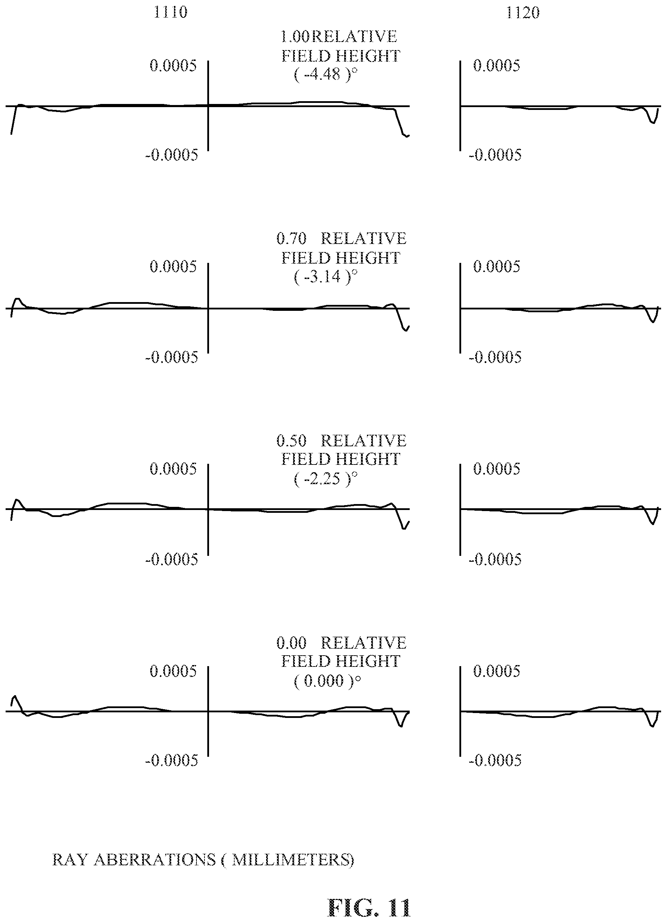

Figure 11 depicts measurements within another exemplary semiconductor inspection system. The graphs displayed in Figure 11 depict measurements from a system in which the nominal wavelength of the system is 266.09 nm and the actual illumination wavelength of the particular illumination source is 266.09 nm. Graph 1110 depicts the tangential geometric ray aberration at various relative field heights. Graph 1120 depicts the sagittal geometric ray aberration at various relative field heights. In this example, sphero-chromatic aberration is minimized and no additional correction is necessary.

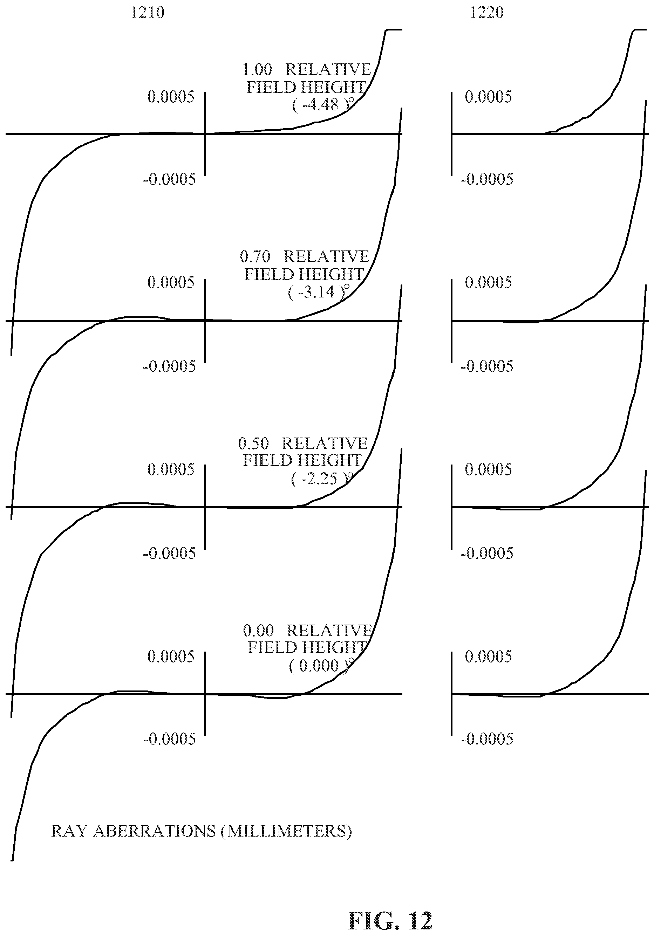

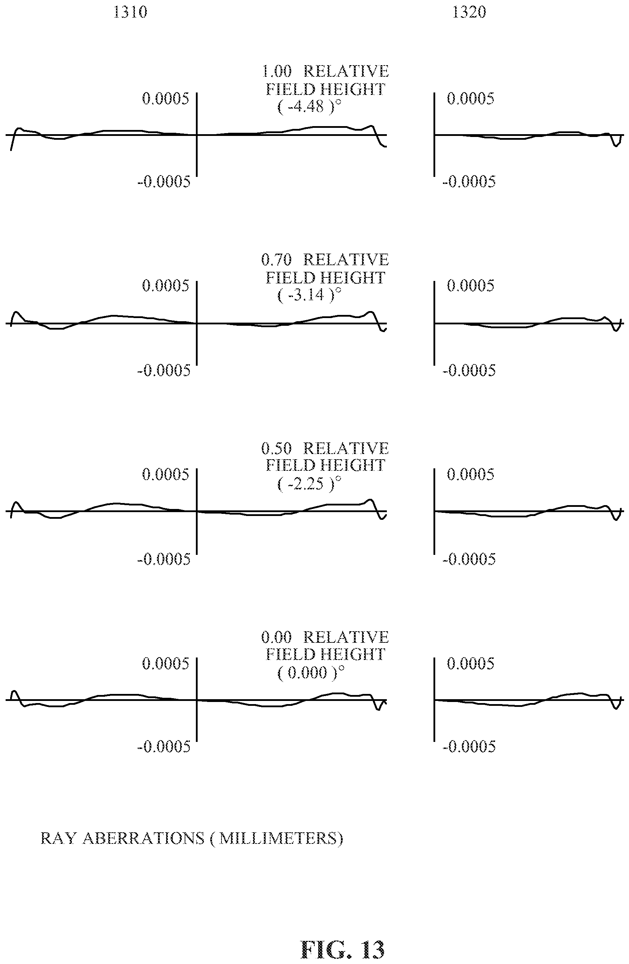

Figures 12 and 13 respectively depict measurements within another exemplary semiconductor inspection system before and after the sphero-chromatic aberration correction described above has been applied. The graphs displayed in Figure 12 depict measurements from a system which has not been corrected for sphero-chromatic aberration. In this example, the nominal wavelength of the system is 266.09 nm and the actual illumination wavelength of the particular illumination source is 266.05 nm. Graph 1210 depicts the tangential geometric ray aberration at various relative field heights. Graph 1220 depicts the sagittal geometric ray aberration at various relative field heights.

The graphs in Figure 13 depict the same system as depicted in Figure 12 after sphero-chromatic aberration correction according to an embodiment of the present invention has been applied. The nominal wavelength of the semiconductor inspection system has been changed to correspond to the actual illumination wavelength of 266.05 nm. Graph 1310 depicts the tangential geometric ray aberration at various relative field heights for the same system after correction has been applied. As can be seen by comparison to Graph 1210, tangential geometric ray aberration has been significantly reduced in the corrected system. Graph 1320 depicts the sagittal geometric ray aberration at various relative field heights after correction has been applied. As can be seen by comparison to Graph 1220, sagittal geometric ray aberration has been significantly reduced in the corrected system.

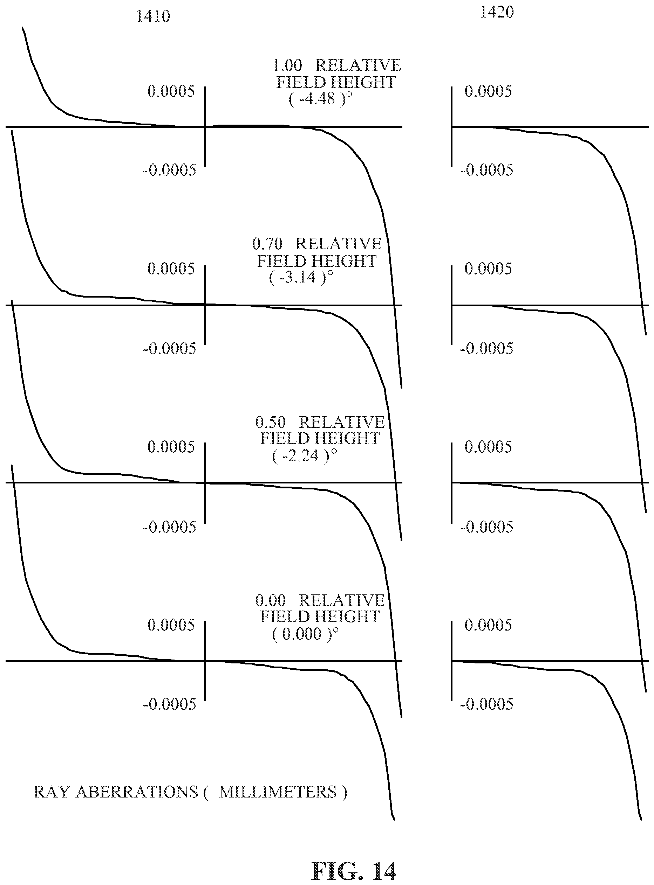

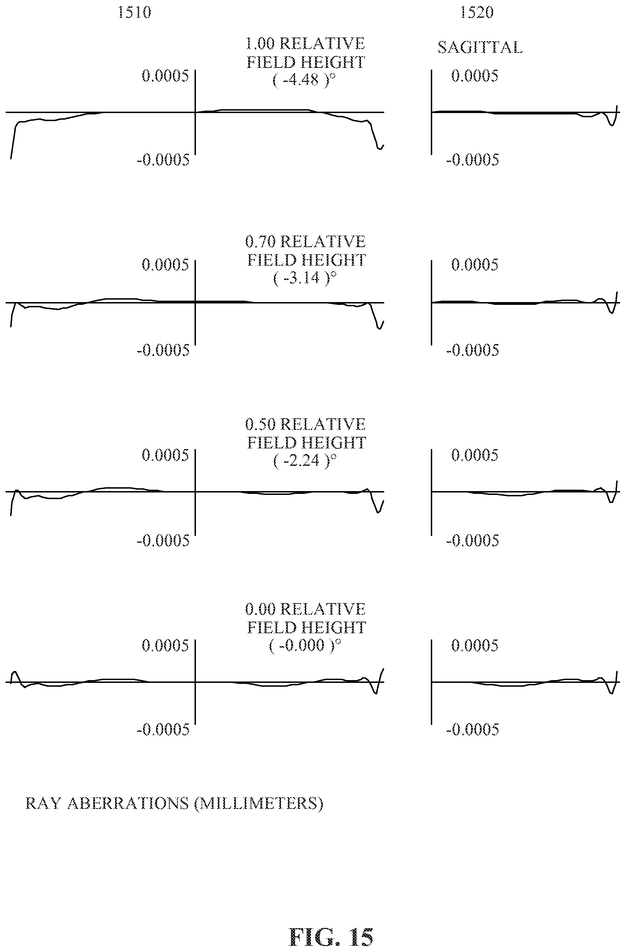

Figures 14 and 15 respectively depict measurements within another exemplary semiconductor inspection system before and after the sphero-chromatic aberration correction described above has been applied. The graphs displayed in Figure 14 depict measurements from a system which has not been corrected for sphero-chromatic aberration. In this example, the nominal wavelength of the system is 266.09 nm and the actual illumination wavelength of the particular illumination source is 266.13 nm. Graph 1410 depicts the tangential geometric ray aberration at various relative field heights. Graph 1420 depicts the sagittal geometric ray aberration at various relative field heights.

The graphs in Figure 15 depict the same system as depicted in Figure 14 after sphero-chromatic aberration correction according to an embodiment of the present invention has been applied. The nominal wavelength of the semiconductor inspection system has been changed to correspond to the actual illumination wavelength of 266.13 nm. Graph 1510 depicts the tangential geometric ray aberration at various relative field heights for the same system after correction has been applied. As can be seen by comparison to Graph 1410, tangential geometric ray aberration has been significantly reduced in the corrected system. Graph 1520 depicts the sagittal geometric ray aberration at various relative field heights after correction has been applied. As can be seen by comparison to Graph 1420, sagittal geometric ray aberration has been significantly reduced in the corrected system.

Embodiments of the present invention additionally allow for an increased field of view and increased numerical aperture.

Although specific reference may have been made above to the use of embodiments of the invention in the context of optical lithography, it will be appreciated that embodiments of the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

## Claims

1. A semiconductor inspection system (400), comprising: a DUV laser (410) configured to emit laser light at a specified wavelength; a telescope system (420) configured to receive the laser light from the DUV laser (410); and an objective lens system (430) configured to receive the laser light from the telescope system (420) and transmit the laser light at the specified wavelength to a surface, **characterised in that** the telescope system (420) comprises at least one lens (422) that is moveable along an optical axis of the telescope system (420) to compensate for sphero-chromatic aberration caused by drift of the wavelength of the laser light away from the specified wavelength; wherein the moveable lens (422) has an absolute value of optical power in the range of 0.002 to 0.01.

2. The semiconductor inspection system (400) of claim 1, wherein the specified wavelength is in the Deep Ultra Violet (DUV) range of approximately 126 nm to 428 nm.

3. The semiconductor inspection system (400) of claim 1, further comprising a detector (4) configured to detect light reflected from the surface.

4. The semiconductor inspection system (400) of claim 1, further comprising a controller (PU) configured to control a position of the moveable lens (422).

5. The semiconductor inspection system (400) of claim 1, wherein the moveable lens (422) is comprised of fused silica.

6. A method for reducing an effect of a wavelength drift of a DUV laser light source in a semiconductor inspection system (400), wherein the semiconductor inspection system comprises:
an DUV laser (410) configured to emit laser light at a specified wavelength; a telescope system (420) configured to receive the monochromatic laser light from the DUV laser (410); and an objective lens system (430) configured to receive monochromatic laser light from the telescope system (420) and transmit the monochromatic laser light at the specified wavelength to a surface,
wherein the method comprises moving at least one lens (422) of the telescope system (420) along an optical axis of the telescope system (420) to compensate for sphero-chromatic aberration caused by drift of the wavelength of the monochromatic laser light away from the specified wavelength; and
wherein the moveable lens (422) has an absolute value of optical power in the range of 0.002 to 0.01.

## Patentansprüche

1. Ein Halbleiterprüfsystem (400), das Folgendes beinhaltet: einen DUV-Laser (410), der konfiguriert ist, um Laserlicht mit einer spezifizierten Wellenlänge zu emittieren; ein Teleskopsystem (420), das konfiguriert ist, um das Laserlicht von dem DUV-Laser (410) zu empfangen; und ein Objektivlinsensystem (430), das konfiguriert ist, um das Laserlicht von dem Teleskopsystem (420) zu empfangen und das Laserlicht mit der spezifizierten Wellenlänge zu einer Oberfläche weiterzuleiten, **dadurch gekennzeichnet, dass** das Teleskopsystem (420) mindestens eine Linse (422) beinhaltet, die entlang einer optischen Achse des Teleskopsystems (420) beweglich ist, um eine durch eine Drift der Wellenlänge des Laserlichts weg von der spezifizierten Wellenlänge verursachte sphärochromatische Aberration zu kompensieren; wobei die bewegliche Linse (422) einen Absolutwert der Brechkraft im Bereich von 0,002 bis 0,01 aufweist.

2. Halbleiterprüfsystem (400) gemäß Anspruch 1, wobei die spezifizierte Wellenlänge in dem tiefen Ultraviolettbereich (DUV-Bereich) von ungefähr 126 nm bis 428 nm liegt.

3. Halbleiterprüfsystem (400) gemäß Anspruch 1, das ferner einen Detektor (4) beinhaltet, der konfiguriert ist, um von der Oberfläche reflektiertes Licht zu detektieren.

4. Halbleiterprüfsystem (400) gemäß Anspruch 1, das ferner eine Steuereinheit (PU) beinhaltet, die konfiguriert ist, um eine Position der beweglichen Linse (422) zu steuern.

5. Halbleiterprüfsystem (400) gemäß Anspruch 1, wobei die bewegliche Linse (422) aus Quarzglas besteht.

6. Ein Verfahren zum Reduzieren eines Effekts einer Wellenlängendrift einer DUV-Laserlichtquelle in einem Halbleiterprüfsystem (400), wobei das Halbleiterprüfsystem Folgendes beinhaltet:
einen DUV-Laser (410), der konfiguriert ist, um Laserlicht mit einer spezifizierten Wellenlänge zu emittieren; ein Teleskopsystem (420), das konfiguriert ist, um das monochromatische Laserlicht von dem DUV-Laser (410) zu empfangen; und ein Objektivlinsensystem (430), das konfiguriert ist, um monochromatisches Laserlicht von dem Teleskopsystem (420) zu empfangen und das monochromatische Laserlicht mit der spezifizierten Wellenlänge zu einer Oberfläche weiterzuleiten,
wobei das Verfahren das Bewegen mindestens einer Linse (422) des Teleskopsystems (420) entlang einer optischen Achse des Teleskopsystems (420) zum Kompensieren einer durch eine Drift der Wellenlänge des monochromatischen Laserlichts weg von der spezifizierten Wellenlänge verursachten sphärochromatischen Aberration beinhaltet; und
wobei die bewegliche Linse (422) einen Absolutwert der Brechkraft in dem Bereich von 0,002 bis 0,01 aufweist.

## Revendications

1. Un système d'inspection de semi-conducteur (400), comprenant : un laser DUV (410) configuré afin d'émettre de la lumière laser à une longueur d'onde spécifiée ; un système de télescope (420) configuré afin de recevoir la lumière laser provenant du laser DUV (410) ; et un système de lentille d'objectif (430) configuré afin de recevoir la lumière laser provenant du système de télescope (420) et de transmettre la lumière laser à la longueur d'onde spécifiée à une surface, **caractérisé en ce que** le système de télescope (420) comprend au moins une lentille (422) qui est mobile le long d'un axe optique du système de télescope (420) afin de compenser une aberration sphéro-chromatique causée par une dérive de la longueur d'onde de la lumière laser à l'écart de la longueur d'onde spécifiée ; où la lentille mobile (422) possède une valeur de puissance optique absolue comprise dans l'intervalle allant de 0,002 à 0,01.

2. Le système d'inspection de semi-conducteur (400) de la revendication 1, où la longueur d'onde spécifiée est dans le domaine de l'ultraviolet profond (DUV) allant d'approximativement 126 nm à 428 nm.

3. Le système d'inspection de semi-conducteur (400) de la revendication 1, comprenant en sus un détecteur (4) configuré afin de détecter de la lumière réfléchie depuis la surface.

4. Le système d'inspection de semi-conducteur (400) de la revendication 1, comprenant en sus un organe de contrôle (PU) configuré afin de contrôler une position de la lentille mobile (422).

5. Le système d'inspection de semi-conducteur (400) de la revendication 1, où la lentille mobile (422) est composée de silice fondue.

6. Une méthode pour réduire un effet d'une dérive de longueur d'onde d'une source de lumière laser DUV dans un système d'inspection de semi-conducteur (400), où le système d'inspection de semi-conducteur comprend :
un laser DUV (410) configuré afin d'émettre de la lumière laser à une longueur d'onde spécifiée ; un système de télescope (420) configuré afin de recevoir la lumière laser monochromatique provenant du laser DUV (410) ; et un système de lentille d'objectif (430) configuré afin de recevoir de la lumière laser monochromatique provenant du système de télescope (420) et de transmettre la lumière laser monochromatique à la longueur d'onde spécifiée à une surface,
où la méthode comprend le fait de faire se mouvoir au moins une lentille (422) du système de télescope (420) le long d'un axe optique du système de télescope (420) afin de compenser une aberration sphéro-chromatique causée par une dérive de la longueur d'onde de la lumière laser monochromatique à l'écart de la longueur d'onde spécifiée ; et
où la lentille mobile (422) possède une valeur de puissance optique absolue comprise dans l'intervalle allant de 0,002 à 0,01.
